# EUROPEAN PATENT APPLICATION

(11) **EP 1 298 234 A2**
(43) Date of publication of application: **02.04.2003**
(21) Application number: 02021906.9
(22) Date of filing: 27.09.2002
(51) Int. Cl.: C30B 29/36, C30B 25/18

(54) **Method of manufacturing a single crystal substrate**

(30) Priority: 27.09.2001 JP 2001295703
(71) Applicant: HOYA CORPORATION, Shinjuku-ku, Tokyo 161-8525 (JP)
(72) Inventor: Kawahara, Takamitsu, Kawasaki-shi, Kanagawa 213-0031 (JP); Nagasawa, Hiroyuki, Hachiouji-shi, Tokyo 192-0373 (JP); Yagi, Kuniaki, Ome-shi, Tokyo 198-0036 (JP)
(74) Representative: Zimmermann, Gerd Heinrich

(57) **Abstract**

Provided is a method of facilitating the manufacture of single crystal substrates of silicon carbide and the like even with a large surface area by employing a method of dividing a crystal layer or substrate of silicon carbide or the like into plate-shape. The first method comprises the steps of forming a fracture layer over all or at least a portion of one of the principal surfaces of a first substrate; forming a second single crystal layer over the fracture layer on the first substrate to a thickness affording adequate self-sustaining strength; and cutting at the fracture layer formed on the first substrate to separate the second single crystal layer from the first substrate and obtain a single crystal substrate. The second method comprises the steps of forming an ion implantation layer by implanting ions into all or at least a portion of the surface of one of the principal surfaces of a first substrate; forming a second single crystal layer on the ion-implanted principal surface to a thickness affording adequate self-sustaining strength, heating the composite substrate obtained to form a void layer by forming voids in the ion implantation layer formed on said first substrate; and cutting said first substrate at said void layer to separate the second single crystal layer from the first substrate and obtain a single crystal substrate. The third method comprises the steps of forming by anodization a porous layer on all or at least a portion of one of the principal surfaces of a first substrate; forming a second single crystal layer on said porous layer of the first substrate to a thickness affording adequate self-sustaining strength; and cutting said first substrate at said porous layer to separate the second single crystal layer from the first substrate and obtain a single crystal substrate.

## Description

The present invention relates to a method of manufacturing single crystal substrates. More particularly, the present invention relates to a method of manufacturing silicon carbide single crystal substrates useful as single crystal substrate for semiconductor materials. The present invention provides a method of manufacturing with high quality and at low cost the single crystal substrates employed as electronic materials.

In recent years, silicon carbide has attracted attention as a material for use in devices operating at high temperature and high-power devices. The method of growing silicon carbide by chemical vapor phase growth method on silicon substrates or silicon carbide substrates is widely employed. However, since little silicon carbide of the quality required for use as a base substrate is available and its cost is high, the method of forming silicon carbide on a silicon carbide substrate lends itself poorly to large-scale production. Further, since there are currently almost no large-diameter silicon carbide substrates available commercially, it is difficult to homoepitaxially grow silicon carbide over large areas. Accordingly, silicon carbide is generally grown on silicon substrates.

However, when forming silicon carbide on a silicon substrate, propagation planar defects (causing voltage leaks and electron scattering when the silicon carbide is employed as a semiconductor device material) end up being incorporated into the silicon carbide, making it difficult to obtain silicon carbide having adequate characteristics as a semiconductor material. Further, although silicon carbide grown at high temperature can generally be expected to be of high quality, the base substrate silicon has a melting point lower than that of silicon carbide. Thus, the growth temperature of silicon carbide is limited to the melting point of the silicon substrate or less.

Under this background, proposed was a method of growing silicon carbide on a silicon substrate in which undulations running parallel in one direction are provided to eliminate planar defects propagating within the silicon carbide (Japanese Unexamined Patent Publication (KOKAI) No. 2000-303349). This method causes planar defects to collide and be eliminated while growing silicon carbide. The greater the thickness of the silicon carbide, the lower the defect density in the surface that is grown. That is, it suffices to grow the silicon carbide as thick as possible to obtain high-quality silicon carbide of low defect density. Silicon carbide obtained by this method may be subsequently separated from the substrate and employed as it is as a silicon carbide substrate, or sliced for use as silicon carbide substrates.

This method yields silicon carbide substrates of large surface area. Homoepitaxial growth may be conducted again on the large surface area silicon carbide substrates obtained to increase the cumulative thickness and thus eliminate planar defects. Further, in contrast to silicon substrates, there is no limitation that the silicon carbide growth temperature must be the melting point of base substrate for growth or less, it is possible to set the silicon carbide growth temperature at high temperature, yielding higher quality silicon carbide. Accordingly, it is desirable to slice the silicon carbide obtained by this method for use as substrates.

The thickness of the silicon carbide obtained by vapor phase growth method employed for forming silicon carbide in the above-described method is currently from about 0.5 to 1 mm. One method of slicing silicon carbide of about this thickness is a cutting method with a diamond wire saw. However, due to the relatively high hardness of silicon carbide, there is substantial abrasion of the diamond wire saw, incurring great cost. Further, a cutting allowance (machining allowance) of 300 to 500 micrometers becomes necessary in mechanical slicing methods employing blades, such as diamond wire saws. Unusable portion is excessive large relative to the thickness grown, remarkably compromising the efficiency of large-quantity production. Further, in practical terms, it is quite difficult to slice a substrate with a large surface area, such as 6 inches if the thickness is 1 mm.

By the way, known is a method in which smart cutting technology is applied in manufacturing a silicon carbide substrate to cut a silicon carbide layer serving as a base of the silicon carbide substrate from the silicon substrate (Japanese Unexamined Patent Publication (KOKAI) Heisei No. 10-223496). In this method, hydrogen atoms are first ion-implanted to the prescribed depth of the silicon carbide layer that has been formed on the silicon substrate, after which a heat treatment is conducted to form a void layer in the silicon carbide layer. Next, the silicon carbide layer surface is adhered to a flat plate, and the silicon carbide layer is divided in two at the void layer. The divided silicon carbide layer adhering to the flat plate is removed from the flat plate and silicon carbide layer is homoepitaxially grown on the surface of the silicon carbide layer that had been adhered to the flat plate (the opposite surface from that divided by the void layer). In this method, prior to conducting homoepitaxial growth, a reinforcement substrate is bonded to the silicon carbide layer to strengthen the thin (several micrometer) silicon carbide layer that has been separated from the flat plate. The plate used for reinforcement must be separated following homoepitaxial growth. Thus, in this method, the silicon carbide layer that has been separated from the thin plate must be bonded to and separated from a reinforcement plate. Further, in the course of separation, some form of cutting is again required. Still further, there are limits to the depth to which it is possible to conduct ion implantation to form a void layer in the silicon carbide layer. As a result, the thickness of the silicon carbide layer obtained by separation at the void layer is limited to about several micrometers, even at a maximum acceleration energy. Accordingly, when preparing large surface area silicon carbide substrates, it is difficult, in view of strength, to handle and maintain the silicon carbide layer that is divided at the void layer at a thickness of about several micrometers.

The present invention intends to overcome some of the above problems. The object is solved by the method of manufacturing a single crystal substrate according to independent claims 1 to 3. Further advantages, features, aspects and details of the invention are evident from the dependent claims, the description and the accompanying drawings.

Accordingly, it is an object of the present invention is to provide a method of facilitating the manufacture of single crystal substrates of silicon carbide and the like even with a large surface area by employing a method of dividing a crystal layer or substrate of silicon carbide or the like into plate-shape. In particular, it is an object of the present invention is to provide a method of manufacturing silicon carbide single crystal substrates of large area and low planar defect densities.

The present invention relates to a method of manufacturing a single crystal substrate (hereinafter referred to as the "first manufacturing method of the present invention") comprising the steps of:
forming a fracture layer over all or at least a portion of one of the principal surfaces of a first substrate;
forming a second single crystal layer over the fracture layer on the first substrate; and
cutting at the fracture layer formed on the first substrate to separate the second single crystal layer from the first substrate and obtain a single crystal substrate.

The present invention further relates to a method of manufacturing a single crystal substrate (hereinafter referred to as the "second manufacturing method of the present invention") comprising the steps of:
forming an ion implantation layer by implanting ions into all or at least a portion of the surface of one of the principal surfaces of a first substrate;
forming a second single crystal layer on the ion-implanted principal surface,
heating the composite substrate obtained to form a void layer by forming voids in the ion implantation layer formed on said first substrate; and
cutting said first substrate at said void layer to separate the second single crystal layer from the first substrate and obtain a single crystal substrate.

Further, the present invention relates to a method of manufacturing a single crystal substrates (referred to hereinafter as the "third manufacturing method of the present invention") comprising the steps of:
forming by anodization a porous layer on all or at least a portion of one of the principal surfaces of a first substrate;
forming a second single crystal layer on said porous layer of the first substrate; and
cutting said first substrate at said porous layer to separate the second single crystal layer from the first substrate and obtain a single crystal substrate.

The invention is also directed to products obtainable by the disclosed methods and products having the disclosed advantageous properties.

The invention will be better understood by reference to the following description of embodiments of the invention taken in conjunction with the accompanying drawings, wherein
Fig. 1 shows a scheme of Example 1.
Fig. 2 shows a method of dividing a substrate from a porous layer by water jet.
Fig. 3 shows a method of dividing a substrate from a porous layer by wet etching.

In the first manufacturing method of the present invention, a fracture layer of desired thickness is formed over all or at least a portion of one of the principal surfaces of a first substrate. Here, the term "fracture layer" may be a porous layer or void layer, for example. Further, the thickness of the fracture layer that is formed may be 1 to 5 micrometers, preferably 1 to 10 micrometers.

In the second manufacturing method of the present invention, an ion implantation layer is formed by implanting ions in over all or at least a portion of one of the principal surfaces of a first substrate to a prescribed depth from the surface. The ions that are implanted may be, for example, selected from hydrogen, helium, or halogens such as fluorine or chlorine. The depth of ion implantation may be 0.5 to 5.0 micrometers, for example. The density of ions implanted may be 1 x 10¹⁶/cm² to 1 x 10¹⁸/cm².

In the third manufacturing method of the present invention, a porous layer is formed by anodization on over all or at least a portion of one of the principal surfaces of a first substrate to a prescribed depth from the surface. The anodization may be conducted with a mixed solution of hydrofluoric acid and ethanol. The porous layer area includes two layers of differing porosity. For example, the porosity of the porous layer near the surface on which the single crystal layer is grown may be made 1 to 10 percent to maintain surface smoothness and strength (porous layer A), and the porosity of the porous layer formed as the fracture layer may be made 30 to 90 percent to achieve low strength (porous layer B). Porosity can be controlled by adjusting the current density during anodization. The depth of the porous layer can be controlled by means of the oxidation period during anodization. The depth of the porous layer formed by anodization may be made 2 to 100 micrometers, preferably 50 to 70 micrometers for porous layer A, for example. The fracture layer in the form of porous layer B may be formed at a depth of 2 to 150 micrometers, preferably from 50 to 90 micrometers (with a fracture layer thickness of 0.5 to 50 micrometers, preferably 0.5 to 20 micrometers).

Further, the porosity of the porous layer is denoted by the ratio by volume of voids; the greater the amount of voids, the less mechanical strength afforded. It is impossible to directly position the porous layer in the middle of the plate, and it is gradually formed from the surface by oxidation in the direction of depth. The longer the oxidation time, the deeper the oxidation (porous treatment). When the current density is set high during oxidation, the pore diameter increases from that point on.

Next, a second single crystal layer is formed over the first substrate on which an ion implantation layer or porous layer has been formed. The thickness of the second single crystal layer need only afford adequate self-sustaining strength. What is meant by the second single crystal layer having a thickness affording adequate self-sustaining strength is a thickness at which the second single crystal layer does not break when cut and separated from the first substrate. For example, this thickness may be equal to or greater than 50 micrometers, preferably equal to or greater than 100 micrometers, and more preferably, from 100 to 500 micrometers. The second single crystal layer may be, for example, a silicon carbide single crystal, and is preferably silicon carbide obtained by epitaxial growth while inheriting the crystal orientation of the first substrate.

Silicon starting material gases suitable for use in the precipitation of silicon carbide from vapor phase are: dichlorosilane (SiH₂Cl₂), SiH₄, SiCl₄, SiHCl₃, and other silane compound gases. Starting material carbon gases suitable for use are acetylene (C₂H₂), CH₄, C₂H₆, C₃H₈, and other hydrocarbon gases.

In the first manufacturing method of the present invention, the composite substrate obtained is cut at the fracture layer formed on the first substrate to separate the second single crystal layer from the first substrate and obtain a single crystal substrate. The single crystal substrate thus obtained consists of a portion of the first substrate that is cut from the second single crystal layer. Cutting at the fracture layer may be conducted, for example, by laser, ultrasonic waves, wet etching, splitting with a diamond cutter, blowing gas (gas pressure), and water jet (water pressure).

In the second manufacturing method of the present invention, the composite substrate obtained is heated to form voids in the ion implantation layer formed in the first substrate, forming a void layer. The heating to form voids in the ion implantation layer may be conducted, for example, in air or under reduced pressure at a heat treatment temperature of 400 to 900°C for 1 to 30 minutes.

Further, the first substrate is cut at the void layer and the second single crystal layer is separated from the first substrate to obtain a single crystal substrate. The single crystal substrate thus obtained consists of a portion of the first substrate that is cut from the second single crystal layer. Cutting at the void layer may be conducted, for example, by laser cutter, ultrasonic cutter, wet etching, splitting with a diamond cutter, blowing gas (gas pressure), and water jet (water pressure).

In the third manufacturing method of the present invention, the composite substrate obtained is cut at the porous layer in the first substrate to separate the second single crystal layer from the first substrate and obtain a single crystal substrate. The single crystal substrate thus obtained consists of a portion of the first substrate that is cut from the second single crystal layer. Cutting at the porous layer may be conducted, for example, by laser cutter, ultrasonic cutter, wet etching, splitting with a diamond cutter, blowing gas (gas pressure), and water jet (water pressure).

According to the first manufacturing method of the present invention, even if the substrate has a large area, division can be readily conducted at a boundary in the form of fracture layer formed intentionally. The strength of the fracture layer need only allow for ready cleavage while supporting the single crystal substrate that has been grown. Since the single crystal layer can be thickly formed (to 200 micrometers, for example) in the layer above the fracture layer, the single crystal layer can sustain itself without requiring adhesion to a reinforcement substrate or the like during division. When the fracture layer is not required following division, it may be readily removed by grinding or etching. Further, the first substrate may be reused following separation, thereby reducing the cost of manufacturing single crystal substrates.

According to the second manufacturing method of the present invention, a uniform void layer with large area is formed by ion implantation at any depth within the substrate in the layer form. Since the void layer formed has overwhelmingly weaker strength than other single crystal layer and substrate, a subsequently formed single crystal layer can be readily separated at the ion implantation layer. So long as the subsequently formed single crystal layer has a thickness affording adequate strength to be self-sustaining, handling before and after separation is easy. The thickness of the growth layer need only afford adequate strength for self-sustenance. The first substrate may be reused following separation, thereby reducing the cost of manufacturing single crystal substrates.

According to the third manufacturing method of the present invention, a uniform porous layer with large area is formed by anodization near a base in the form of the first substrate surface. A single crystal layer is then grown thereover. Since the porous layer has weaker mechanical strength than the single crystal layer and base substrate, they can be separated at this layer as boundary. Since a surface upon which epitaxial growth is possible is maintained on the outer layer, a porous layer of small pore diameter can be formed, the anodization conditions can be changed, and a porous layer of large pore diameter can be formed at a depth of about several tens of micrometers, permitting effective division of the base substrate and the grown layer. Further, in the first through third manufacturing methods of the present invention, the cutting allowance when cutting at a porous layer, at equal to or less than 50 micrometers, is kept to about 1/10^{th} (one tenth) that of a wire saw, at 500 micrometers; cutting is thus efficient.

In the third manufacturing method of the present invention, the first substrate can be reused following separation, thereby reducing the cost of manufacturing single crystal substrates.

In the first through third manufacturing methods of the present invention, the first substrate may, for example, be comprised of a single crystal silicon carbide or single crystal silicon substrate. The second single crystal layer may be single crystal silicon carbide obtained by epitaxial growth while inheriting the crystal orientation of the first substrate. That is, the second single crystal layer may be single crystal silicon carbide obtained by epitaxial growth while inheriting the crystal orientation of a single crystal-silicon carbide or single crystal silicon substrate.

The method of precipitating silicon carbide by epitaxial growth while inheriting the crystallinity of the substrate surface may be any method of limiting to within a specific crystal face the propagation orientation of planar defects within the film; chemical vapor deposition (CVD), liquid phase epitaxial growth, sputtering, molecular beam epitaxy (MBE), and the like may all be employed. In the case of CVD, it is also possible to employ a simultaneous source-gas feeding method, not an alternate source-gas feeding method.

By employing single crystal silicon carbide that has been epitaxially grown while inheriting the crystal orientation of single crystal silicon carbide as the second single crystal layer, it is possible at low cost to readily slice-process single crystal SiC, which was difficult to be slice-processed heretofore, and which was expensive by processing with diamond wire saw because wire saw was worn. Further, when there is no issue of cutting allowance, fracture layers with weak strength may be cut with diamond wire saws. In the method, abrasion of wire saw is much less than when cutting silicon carbide portion with high strength. The same effect can be achieved irrespective of the crystalline polymorph of silicon carbide, such as 3C, 4H, 6H, or the like. The same effect can also be achieved irrespective of face orientation.

Conventionally, the silicon substrate has been generally removed by wet etching with fluorine nitrate or an alkali to render the silicon carbide self-sustaining. However, by employing single crystal silicon carbide that has been epitaxially grown while inheriting the crystal orientation of single crystal silicon carbide as the second single crystal layer in the present method, it is possible to readily separate the silicon substrate and the silicon carbide without etching the silicon substrate.

In the first through third methods of the present invention, the first substrate can be either a silicon substrate in which one of the principal surfaces thereof has been subjected to undulation-processing, or a silicon carbide substrate obtained by epitaxially growing silicon carbide on a silicon substrate in which one of the principal surfaces thereof has been subjected to undulation-processing, and the second single crystal layer can be silicon carbide obtained by epitaxial growth while inheriting the crystal orientation of the first substrate.

For example, the silicon substrate subjected to undulation-processing may be the following substrate:
(1) A substrate in which there are plural undulations extending roughly in parallel on the substrate surface upon which the silicon carbide precipitates. These undulations have a centerline average roughness ranging from 3 to 1,000 nm. The inclined surfaces of the undulations have slopes ranging from 1° to 54.7°. Further, in the cross-sections of the undulations perpendicular to their direction of extension, the shape of adjacent portions of inclined surfaces is curved.
(2) A substrate in which there are plural undulations extending roughly in parallel on the substrate surface upon which the silicon carbide precipitates. These undulations have a centerline average roughness ranging from 3 to 1,000 nm. The inclined surfaces of the undulations have slopes ranging from 1° to 54.7°. The substrate is silicon or silicon carbide, and the normal axis of the surface is the [001] orientation. The ratio of {001} faces to the area of the substrate surface does not exceed 10 percent.
(3) A substrate in which there are plural undulations extending roughly in parallel on the substrate surface upon which the silicon carbide precipitates. These undulations have a centerline average roughness ranging from 3 to 1,000 nm. The inclined surfaces of the undulations have slopes ranging from 1° to 54.7°. The substrate is silicon or cubic silicon carbide, and the normal axis of the surface is the [111] orientation. The ratio of {111} faces to the area of the substrate surface does not exceed 3 percent.
(4) A substrate in which there are plural undulations extending roughly in parallel on the substrate surface upon which the silicon carbide precipitates. These undulations have a centerline average roughness ranging from 3 to 1,000 nm. The inclined surfaces of the undulations have slopes ranging from 1° to 54.7°. The substrate is hexagonal silicon carbide, and the normal axis of the surface is the [1,1,-2,0] orientation. The ratio of {1,1,-2,0} faces to the area of the substrate surface does not exceed 10 percent.
(5) A substrate in which there are plural undulations extending roughly in parallel on the substrate surface upon which the silicon carbide precipitates. These undulations have a centerline average roughness ranging from 3 to 1,000 nm. The inclined surfaces of the undulations have slopes ranging from 1° to 54.7°. The substrate is hexagonal silicon carbide, and the normal axis of the surface is the [0,0,0,1] orientation. The ratio of {0,0,0,1} faces to the area of the substrate surface does not exceed 3 percent.
In the substrates of (2) to (5), the shape of the adjacent portions of the inclined surfaces is desirably curved in the cross-section perpendicular to the direction in which the undulations on the substrate surface extend.

The silicon substrate subjected to undulation-processing may also be the substrate described in Japanese Unexamined Patent Publication (KOKAI) No. 2000-178740. The substrate described in Japanese Unexamined Patent Publication (KOKAI) No. 2000-178740 is provided with plural undulations extending in parallel in a single direction on part or all of the substrate surface. More specifically, for example, the spacing of the tops of the undulations on the substrate surface is equal to or greater than 0.01 micrometer and equal to or less than 10 micrometers, and the difference in height of the undulations is equal to or greater than 0.01 micrometer and equal to or less than 20 micrometers. Further, the slope of inclined surfaces on the undulations may be equal to or greater than 1° and equal to or less than 55°. Further, this substrate may be (1) single crystal SiC, on which the substrate surface is (001) face and undulations extending in parallel with the [110] orientation are provided on its surface; (2) single crystal 3C-SiC, on which the substrate surface is (001) face and undulations extending in parallel with the [110] orientation are provided on its surface (2); or (3) hexagonal single crystal SiC, on which the substrate surface is (1,1,-2,0) face and undulations extending in parallel with the [1,-1,0,0] orientation or the [0,0,0,1] orientation are provided on its surface.

For example, photolithographic techniques, press processing techniques, laser processing, ultrasound processing techniques, and grinding processing techniques may be employed to form undulations of the above-described shape on the substrate surface.

In the manufacturing methods of the present invention, a thick silicon carbide (for example, 200 micrometers) is formed by epitaxial growth on the layer to be separated. When a silicon substrate that has been processed to impart undulations such as those described above is employed as the first single crystal substrate, the thicker the silicon carbide formed thereover, the greater the effect of eliminating planar defects. Thus, separation of the substrate is facilitated and, following separation of the growth layer from the substrate, it is possible to obtain a high-quality single crystal SiC substrate in which planar defects have been eliminated.

The methods of the present invention permit the reuse of the first single crystal layer, reducing cost.

The single crystal substrates comprising a second single crystal layer that are obtained by the first through third manufacturing methods of the present invention may be employed as the first substrate and the first through third manufacturing methods of the present invention repeated again to manufacture single crystal substrates.

By repeating the step in which the growth layer is employed as the base substrate in this manner, the cumulative film thickness of silicon carbide can be increased, and as a result, high-quality silicon carbide can be obtained in which the density of planar defects in the silicon carbide has been further reduced. Further, until now, since the melting point of the silicon in the base substrate has been lower than the melting point of silicon carbide, the temperature at which silicon carbide has been grown has been limited to equal to or less than 1,400°C. In general, it is consider that the higher the temperature at which silicon carbide is grown, the better the quality of the product obtained. By using the single crystal substrate containing the second single crystal layer obtained by the first through third manufacturing methods of the present invention as the first substrate, it is possible to employ a silicon carbide substrate as the base substrate. This permits the growth of high-quality silicon carbide substrates in a high temperature environment without temperature limitation.

In the present invention, it is possible to repeatedly form a fracture layer, void layer, or porous layer (collectively referred to hereinafter as a "fracture layer") and second single crystal layers. In this case, growth of single crystal layers and formation of fracture layers are repeatedly conducted, such as: single crystal layer - fracture layer - single crystal layer - fracture layer, and the like. Finally, the individual fracture layers are sequentially or simultaneously cut to obtain plural substrates comprising single crystal layers at once.

Since repetition increases the cumulative layer thickness, the higher the layer, the fewer the defects in the single crystal substrate obtained. Further, since plural single crystal substrates can be obtained at once from a single first substrate, the first substrate need only be used a few times, which is advantageous to mass production.

The present invention will be described in greater detail below through examples.

### Example 1

The method in which a porous 3C-SiC layer was formed on a 3C-SiC substrate surface, single crystal 3C-SiC was thickly formed on the surface thereof, and the 3C-SiC was separated at the porous layer was implemented.

First, a 3C-SiC (200 micrometers in thickness) layer was formed on the (001) face of a six-inch Si substrate. LPCVD method was employed to form the 3C-SiC. The growth of the 3C-SiC was divided into a substrate surface carbonization step and a 3C-SiC growth step by alternate feeding of source gases. In the carbonization step, the substrate was heated from room temperature to 1,000 to 1,400°C over 120 min in an acetylene atmosphere. Following the carbonization step, the substrate surface was alternately exposed to dichlorosilane and acetylene at 1,000 to 1,400°C to grow 3C-SiC. Table 1 gives the specific conditions in the carbonization step, and Table 2 gives the specific conditions in the 3C-SiC growth step.

**Table 1**

| | |
|---|---|
| Carbonization temperature | 1,000 to 1,400 □ |
| Acetylene flow rate | 10 to 50 sccm |
| Pressure | 20 to 90 mTorr |
| Period of temperature increase | 30 to 120 min |

**Table 2**

| | |
|---|---|
| Growth temperature | 1,000 to 1,400 °C |
| Gas supply method | Alternate feeding of acetylene and dichlorosilane |
| Acetylene flow rate | 10 to 50 sccm |
| Dichlorosilane flow rate | 10 to 500 sccm |
| Interval of feeding each gas | 1 to 5 sec |
| Feeding time of each gas | 1 to 5 sec |
| Maximum pressure | 100 mTorr |
| Minimum pressure | 10 mTorr |

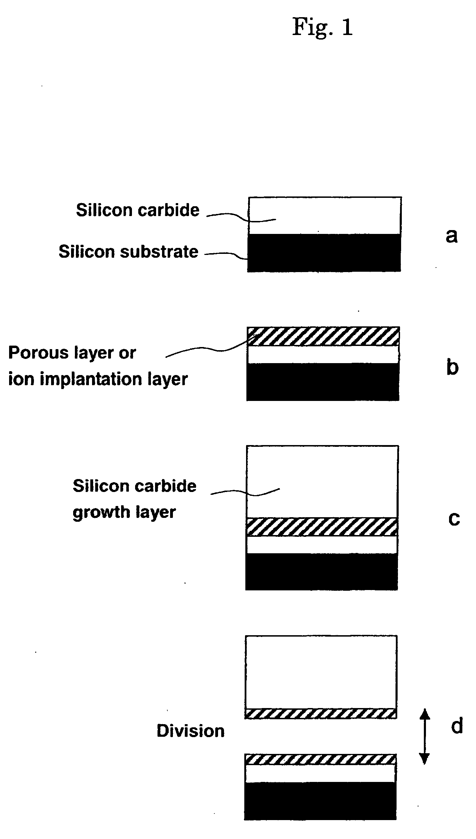

In this manner, it was possible to obtain a 3C-SiC substrate on a six-inch Si substrate (Fig. 1-a).

Next, the 3C-SiC surface was rendered porous by anodization (anodic oxidation) (Fig. 1-b). A mixture of 25 percent hydrofluoric acid and ethanol in a 1:1 ratio was employed as an electrolyte. The electrolyte was charged to a beaker and a silicon carbide anode and a platinum cathode were positioned oppositely. A current density of 1 mA/cm² was applied for 10 min. Subsequently, the current density was raised to 90 mA/cm² and anodization was conducted for 2 min. A porous layer 20 micrometers in thickness was thus formed on the 3C-SiC surface. A porous layer with a pore diameter of 10 to 50 nm and a porosity of about 50 percent was formed from a lower end to 5 micrometers, among 20 micrometers. The pore diameter near the surface was low, at about 0.1 to 1 nm, and the porosity was only several percent. Thus, the surface has a shape fully permitting the homoepitaxial growth of 3C-SiC. 3C-SiC was again formed over this sample surface. The 3C-SiC was formed by the same method as set forth above. In this time, the silicon carbide was formed to a thickness of 500 micrometers to impart self-sustaining strength to the 3C-SiC (Fig. 1-c).

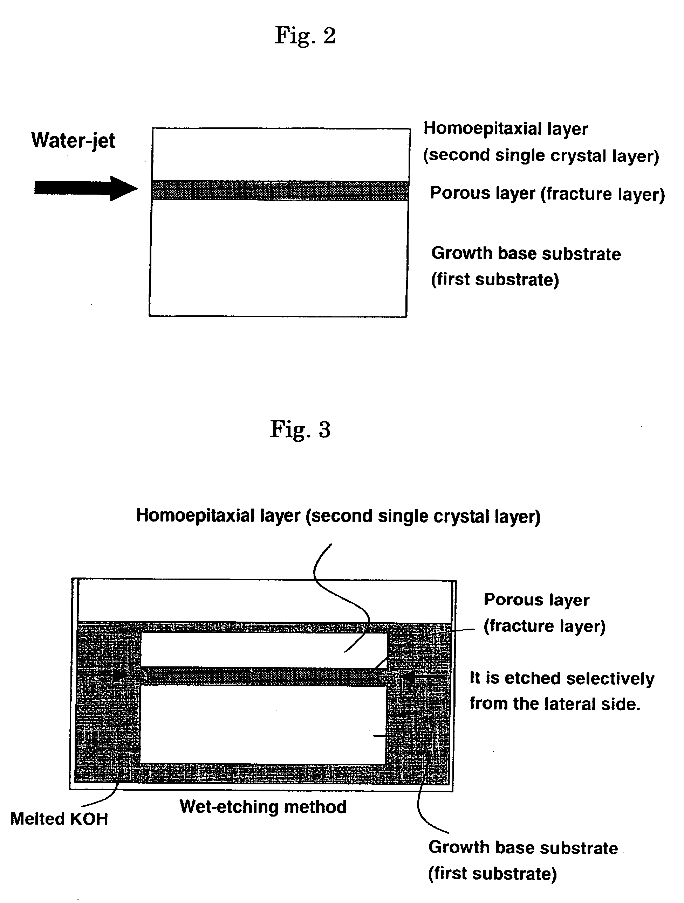

A water jet such as that shown in Fig. 2 (spraying water at high velocity and pressure) was sprayed to the sample that had been formed from the side in the direction of the surface. The porous layer was selectively destroyed to split the wafer at the portion where the porous layer was located, yielding a 3C-SiC substrate 500 micrometers in thickness (Fig. 1-d). It was possible to manufacture six-inch 3C-SiC substrates easily and at extremely low cost. The amount of thickness of the six-inch 3C-SiC that was wasted as a cutting allowance was about 20 micrometers. Cutting was conducted with the water jet under spraying conditions of a nozzle diameter of 0.1 mmϕ and water pressure of 100 kgf/cm² (9.8 MPa). Further, when spraying water jet to the lateral surface of the sample, the sample was rotated to render the spray uniform over the entire lateral surface. Although the jet spray also hit layers other than the fracture layer, the fracture layer with weak mechanical strength was selectively destroyed, permitting uniform destruction over the entire surface. The medium employed in the water jet was water in this time. However, in addition to water, the same results may be achieved using gases, acid-alkali, and other etching reagents and abrasives. A water jet was employed for cutting in this time. However, when a laser is employed, the porous layer may be selectively destroyed in the same manner, permitting splitting of the substrate because the fracture layer was extremely weak. Further, instead of a water jet, when wet etching by immersion of the sample in melted KOH is employed, the porous layer is selectively etched away from the side at an etching rate overwhelmingly faster than that of the single crystal portion, permitting the splitting of the substrate (Fig. 3).

For comparison, a diamond wire saw was used to directly slice single crystal 3C-SiC by the conventional method. Since a cutting allowance of 500 micrometers was required, the substrate thickness was 1 mm on 3C-SiC growth. Cutting of the 3C-SiC wore down the diamond wire saw considerably, and the wire had to be replaced. Further, since the cutting allowance for the 3C-SiC substrate was 500 micrometers, half of the 3C-SiC grown to 1 mm was unusable.

### Example 2

3C-SiC was first formed on the (001) face of a Si substrate. The silicon carbide was formed by LPCVD method. Growth of 3C-SiC was divided into the step of carbonizing the substrate surface and the step of growing 3C-SiC by alternately feeding source gases. In the carbonization step, the substrate was heated from room temperature to a temperature ranging from 1,000 to 1,400°C over 120 min in an acetylene atmosphere. Following the carbonization step, the substrate surface was alternately exposed to dichlorosilane and acetylene at 1,000 to 1,400°C and 3C-SiC was grown. Table 1 above gives the specific conditions of the carbonization step and Table 2 above gives the specific conditions of the 3C-SiC growth step.

Hydrogen ions were implanted into the surface of the 3C-SiC substrate obtained. The ion implantation was conducted at 200 KeV at 1 x 10¹⁷ cm². An ion implantation layer was thus formed at a depth of about 2 micrometers from the sample surface.

3C-SiC was epitaxially grown on the sample surface. The thickness of the 3C-SiC was 500 micrometers. Since the sample was exposed to a high-temperature environment during growth, formed in the ion implantation layer was a depletion layer in which minute holes with a diameter of several nm to several tens of nm were formed at a density of 10¹⁶ to 10¹⁷/cm³. The sample was readily cut at the depletion layer formed, yielding a six-inch, 500 micrometer-thick 3C-SiC substrate. The sample was cut at the depletion layer by the same method used to cut the substrate at the porous layer set forth above.

Although a thickness of about 10 micrometers was required as a cutting allowance, this value was extremely low relative to the cutting allowance required by a diamond wire saw.

### Example 3

3C-SiC was grown to a thickness of 200 micrometers on a Si substrate subjected to undulation-processing.

The undulation-processing was conducted as follows.

Abrasive was rubbed in parallel to the [110] orientation on the substrate surface in an attempt to manufacture a substrate with undulations formed in parallel to the [110] orientation. Commercially available diamond slurry about 9 micrometers in diameter (Hipress made by Engis) and commercially available abrasive cloth (M414 made by Engis) were employed as the abrasives. The cloth was uniformly impregnated with diamond slurry, a Si (001) substrate was placed on a pad, and while applying a pressure of 0.2 kg/cm² to the entire Si (001) substrate, it was moved about 300 times back and forth a distance of about 20 cm over the cloth in parallel with the [110] orientation (unidirectional abrasive treatment). Countless abrasive scratches (undulations) parallel to the [110] orientation were formed on the Si (001) substrate surface.

Since abrasive grits and the like adhered to the surface of the Si (001) substrate that had been subjected to unidirectional abrasive treatment, it was washed with an ultrasonic washer, subsequently washed with a mixed solution (1:1) of hydrogen peroxide in water and sulfuric acid, and then washed with HF solution. After washing, a thermal oxidation film was formed to a thickness of about 1 micrometer on the undulation-processed substrate under the conditions indicated in Table 3 with a heat treatment device. The thermal oxidation film that was formed was removed with diluted hydrofluoric acid. In addition to the desired undulations, numerous fine spike-shaped irregularities and defects were present on the substrate surface, greatly compromising its use as a growth substrate. However, by forming another thermal oxidation film to a thickness of about 1 micrometer, and removing the oxidation film anew, the substrate surface could be etched to about 2,000 Angstroms to obtain extremely smooth undulations on which fine irregularities were removed. Although observation of the wavy cross-section revealed wavy irregularities of unstable and nonuniform size, they were highly dense. The undulations were always continuous. The grooves were 30 to 50 nm in depth and 1 to 2 micrometers in width, with a slope of 3 to 5°.

**Table 3**

| Thermal oxidation condition | |
|---|---|
| Equipment | Atmospheric pressure heat treatment furnace (hot wall type) |
| Temperature | 1,000 to 1,200°C |
| Oxygen flow rate | 1 to 5 slm (100 to 1,000 sccm steam) |
| Diluting gas (argon) flow rate | 1 to 5 slm |
| Processing time | 3 hours |

Following the undulation-processing, the 3C-SiC surface was anodized to form a porous layer. The anodization conditions were identical to those in Example 1. A porous layer 20 micrometers in thickness was formed on the substrate surface. 3C-SiC was then grown again on the sample. The thickness of the silicon carbide was 500 micrometers. Finally, the 500 micrometer 3C-SiC was separated by the same method as in Example 1 from the base substrate side of the sample at the porous layer of the sample.

The etch pit density and twin density of the 3C-SiC obtained were calculated as follows.

The 3C-SiC was exposed to melted KOH (500°C, 5 min), after which the surface was observed by optical microscope. There were 250 etch pits in the form of stacking faults and planar defects (twins, APBs) over the entire six-inch surface, or 1.38/cm². Polar observation by X-ray diffraction rocking curve (XRD) was also conducted in the 3C-SiC [111] orientation, and the twin density was calculated from the ratio of the signal intensity in the [115] plane orientation corresponding to twin planes to the signal intensity in the [111] plane orientation of a normal single crystal surface. As a result, the twin density was found to be equal to or less than 4 x 10⁻⁴ volume percent, which was measurement limit.

Even through the porous layer, the effects of an undulation-processed substrate could be obtained in the growth layer, and a high-quality 3C-SiC substrate could be obtained.

Conventionally, when 3C-SiC was grown on an undulation-processed substrate without forming a layer with a weak mechanical strength, it was difficult to separate the substrate and the growth layer. Alternatively, the use of a diamond wire saw required a minimum 3C-SiC thickness of 1 mm, of which 500 micrometers was deleted as a cutting allowance. According to the present invention, by forming of a layer with weak mechanical strength followed by the growth of 3C-SiC to a thickness of several hundred micrometers, the effect of undulation substrate (undulation-processed substrate) can be exerted on the growth layer, while the growth layer can be readily separated.

### Example 4

Employing the six-inch 3C-SiC substrate 500 micrometers in thickness obtained in Example 3 as a base substrate, 3C-SiC was homoepitaxially grown. The surface of the 3C-SiC was employed as the growth surface.

To slice the 3C-SiC after growth, the 3C-SiC substrate employed as a base was anodized, forming a porous layer near the surface. The anodization conditions were identical to those described in Example 1. 3C-SiC was grown on the sample. The thickness of the growth layer was 200 micrometers. The sample obtained was then split at the porous layer, yielding a 3C-SiC substrate 200 micrometers in thickness.

The subsequently grown 3C-SiC combined with the base 3C-SiC had a cumulative film thickness of 700 micrometers (with the portion of 500 to 700 micrometers in the 700 micrometers that were grown).

The etch pit density and twin density of the 3C-SiC obtained were calculated as follows.

The 3C-SiC was exposed to melted KOH (500°C, 5 min), after which the surface was observed by optical microscope. There were 240 etch pits in the form of stacking faults and planar defects (twins, APBs) over the entire six-inch surface, or 1.36/cm². Polar observation by X-ray diffraction rocking curve (XRD) was also conducted in the 3C-SiC [111] orientation, and the twin density was calculated from the ratio of the signal intensity in the [115] plane orientation corresponding to twin planes to the signal intensity in the [111] plane orientation of a normal single crystal surfaces. As a result, the twin density was found to be equal to or less than 4 x 10⁻⁴ volume percent, which was a measurement limit.

For comparison, the etch pit density and twin density present in silicon carbide about 200 micrometers in thickness (manufactured according to the conditions given in Table 2 with the exception of being grown on a silicon substrate ) that was grown on a silicon substrate were calculated in the following manner.

The 3C-SiC was exposed to melted KOH (500°C, 5 min), after which the surface was observed by optical microscope. There were 900 etch pits in the form of stacking faults and planar defects (twins, APBs) over the entire six-inch surface, or 5.1/cm². Polar observation by X-ray diffraction rocking curve (XRD) was also conducted in the 3C-SiC [111] orientation, and the twin density was calculated from the ratio of the signal intensity in the [115] plane orientation corresponding to twin planes to the signal intensity in the [111] plane orientation of a normal single crystal surface. As a result, the twin density was found to be 2 x 10⁻³ volume percent.

When evaluated by TEM, the planar defect density was high, 2 x 10⁴/cm². It was found that, despite being a silicon carbide substrate of the same 200 micrometers in thickness, the silicon carbide substrate that was grown to a thick cumulative film thickness had an extremely low surface defect density.

According to the methods of the present invention, it is possible to readily separate a silicon carbide substrate from a growth base substrate, permitting the manufacture of large surface area silicon carbide substrates with low defect densities. Further, according to the methods of the present invention, it is possible to obtain a silicon carbide substrate of even lower defect density by formation to greater thickness.

## Claims

1. A method of manufacturing a single crystal substrate comprising the steps of:
forming a fracture layer over all or at least a portion of one of the principal surfaces of a first substrate;
forming a second single crystal layer over the fracture layer on the first substrate; and
cutting at the fracture layer formed on the first substrate to separate the second single crystal layer from the first substrate and obtain a single crystal substrate.

2. A method of manufacturing a single crystal substrate comprising the steps of:
forming an ion implantation layer by implanting ions into all or at least a portion of the surface of one of the principal surfaces of a first substrate;
forming a second single crystal layer on the ion-implanted principal surface,
heating the composite substrate obtained to form a void layer by forming voids in the ion implantation layer formed on said first substrate; and
cutting said first substrate at said void layer to separate the second single crystal layer from the first substrate and obtain a single crystal substrate.

3. A method of manufacturing a single crystal substrates comprising the steps of:
forming by anodization a porous layer on all or at least a portion of one of the principal surfaces of a first substrate;
forming a second single crystal layer on said porous layer of the first substrate; and
cutting said first substrate at said porous layer to separate the second single crystal layer from the first substrate and obtain a single crystal substrate.

4. The method of manufacturing according to any of claims 1 to 3, **characterized in that** the first substrate consists of single crystal silicon carbide, and the second single crystal layer is a single crystal silicon carbide epitaxially grown while inheriting the crystal orientation of the first substrate.

5. The method of manufacturing according to any of claims 1 to 3, **characterized in that** the first substrate is a single crystal silicon substrate, and the second single crystal layer is a single crystal silicon carbide obtained by epitaxial growth while inheriting the crystal orientation of the first substrate.

6. The method of manufacturing according to any of claims 1 to 5, wherein the second single crystal layer has a thickness equal to or higher than 50 micrometers.

7. The method of manufacturing according to any of claims 1 to 3, **characterized in that** the first substrate is either a silicon substrate in which one of the principal surfaces thereof has been subjected to undulation-processing, or a silicon carbide substrate obtained by epitaxially growing silicon carbide on a silicon substrate in which one of the principal surfaces thereof has been subjected to undulation-processing, and the second single crystal layer is silicon carbide obtained by epitaxial growth while inheriting the crystal orientation of the first substrate.

8. A method of manufacturing a single crystal substrate, wherein the method according to any of claims 1 to 3 is conducted employing a single crystal substrate comprising the second single crystal layer which is a substrate manufactured by the method according to any of claims 1 to 3.

9. A product obtainable by a process according to any of claims 1 to 8.
